# EUROPEAN PATENT APPLICATION

(11) **EP 4 783 779 A1**
(43) Date of publication of application: **29.07.2026**
(21) Application number: 25315022.1
(22) Date of filing: 27.01.2025
(51) Int. Cl.: H10F 30/223, H10F 71/00, H10F 77/1226, H10F 77/14

(54) **OPTOELECTRONIC STRUCTURE COMPRISING GROUP-IV MATERIAL AND PHOTONIC INSTRUMENT COMPRISING THE SAME**

(71) Applicant: Commissariat à l'Energie Atomique et aux Energies Alternatives, 75015 Paris (FR); Université Grenoble Alpes, 38400 Saint-Martin-d'Hères (FR)
(72) Inventor: Assali, Simone, 38000 GRENOBLE (FR); Willoquet, Théophile, 38000 GRENOBLE (FR); Pauc, Nicolas, 38000 GRENOBLE (FR); Hartmann, Jean-Michel, 38000 GRENOBLE (FR)
(74) Representative: Hautier IP

(57) **Abstract**

This invention concerns an optoelectronic device (1) comprising:
- a silicon-based substrate (10),
- an array (14) of group-IV based nanowires (13) extending along a z direction, each nanowire (13) comprising:
• a first portion (130) comprising at least one group IV element, the first portion (130) having a first conductivity of a first type of carrier,
• a second portion (132) comprising at least one group IV element, the second portion (132) having a second conductivity of a second type of carrier,
• an active region (131) comprising at least one group IV element, the active region (131) being configured to emit or absorb infrared radiation (3) of wavelength λ, said active region (131) being inter-posed between the first portion (130) and the second portion (132).

## Description

### DOMAIN OF THE INVENTION

The present invention relates to the field of optoelectronics. Its advantageous applications concern optoelectronic devices ranging from the short-wave (SWIR), mid-wave (MWIR), and long-wave infrared (LWIR) such as photodetectors and light emitting diodes, as well as methods for manufacturing the same.

### TECHNOLOGICAL BACKGROUND

Group IV, for instance GeSn, semiconductors are a valuable candidate to implement Si-integrated low-cost infrared photonic devices (for instance in an operational range from 0.8 µm to 20 µm) that could compete with the more established III-V and II-VI semiconductor infrared technologies.

Ill-V and II-VI semiconductor infrared technologies are commonly made using InSb (typical operational range from 1 µm to 5.5 µm), HgCdTe (typical operational range from 3 µm to 7 µm), .and CdSe (typical operational range from 1 µm to 5.5 µm) compounds, to name a few. The inherently high cost resulting from the use of expensive III-V and II-VI materials combined with the challenging integration with the Silicon-based manufacturing processes and the frequent need for cryogenic cooling, result in expensive optoelectronic devices operating across the short-wave infrared (SWIR, typically from 1,5 µm to 3 µm wavelengths) and mid-wave infrared (MWIR, typically from 3 µm to 8 µm wavelengths).

Group IV semiconductors are typically epitaxially grown on a silicon (Si) substrate, which facilitates their integration with the Silicon-based manufacturing processes. GeSn-based photodetectors are for instance commonly fabricated from doped GeSn thin film multi-layers grown on a Ge on Si substrate (Ge/Si) by etching, passivation, and contact deposition into arrays of final devices, each of them with an active area typically larger than 10 µm in diameter. Over the last decade, group IV-based photodetectors were demonstrated to operate in the near-wave infrared (NWIR, typically from 0,8 µm to 1,5 µm wavelengths), and SWIR at room temperature and further extend into the MWIR with lower efficiency. Their operation in the long-wave infrared (LWIR) remains however strongly limited due to low material quality.

In the example of GeSn-based photodetectors, defects contribute to their dark current being typically three to four orders of magnitude higher than InGaAs-based detectors operating in the SWIR. As a result of this, GeSn-based photodetectors can deliver specific detectivities in the SWIR that are typically more than two orders of magnitude lower than leading III-V and II-VI technologies. The low device efficiency thus poses severe challenges with the implementation and the adoption of GeSn-based optoelectronic devices in infrared technologies for both civilian and military markets.

WO2021217256 A1 describes an optoelectronic device comprising a Group IV-based heterostructure micro-disks on a Si-based substrate. This device remains however limited to overcome the above-mentioned disadvantages.

It is therefore an object of the present invention to propose a solution to improve the performance of Group IV-based optoelectronic devices.

Other objects, features and advantages of the present invention will become apparent from the following description and accompanying drawings. It is understood that other advantages may be incorporated.

### SUMMARY

To achieve this objective, according to a first aspect the present invention provides an optoelectronic device comprising:
- a substrate,
- an array of group-IV based heterostructures, the optoelectronic device being characterized in that the heterostructures are nanowires forming an array and extending along a z direction, each nanowire comprising:
   - a first portion comprising at least one group IV element, the first portion having a first conductivity of a first type of carrier,
   - a second portion comprising at least one group IV element, the second portion having a second conductivity of a second type of carrier,
   - an active region comprising at least one group IV element, the active region being configured to emit or absorb infrared radiation of wavelength λ, said active region being interposed between the first portion and the second portion.

Shaping the optically active Group-IV thin material into a nanowire array strongly increases light absorption compared to thin films, even at room temperature. The nanowire structuration enables tuning geometrical parameters at the nanometer scale, such as shape, diameter and/or pitch, which provide spectral tuning of the absorption or emission peak across a broad wavelength range. For instance, the nanowire array can be engineered with nearly constant absorption over a broad wavelength range or else exhibit enhanced absorption in narrower spectral windows by tailoring the leaky mode resonance (LMR) in the nanowires. The possible light engineering management offered by nanostructuring offers extra levers to play with such as optimized mode matching with the junction position. This is of high importance since in non-optimized devices, a significant part of the generated electron-hole pairs is generated far from the junction area and thus are lost for photocurrent generation for many of them.

Nanostructuring Group IV thin films to form a nanowire array therefore enables fabricating high efficiency infrared optoelectronic devices, and especially infrared photodetectors. The invention further requires less cooling, and preferably enables the use of the optoelectronic device at room temperature. The invention helps to close the efficiency gap with high-cost, cooled III-V and II-VI semiconductor photodetectors in the same spectral range.

A second aspect of the present invention concerns a photonic instrument comprising at least one, preferably at least two, optoelectronic device(s) according to the first aspect.

A third aspect of the present invention concerns a method for manufacturing the opto-electronic device according to the first aspect, comprising:
- providing a structure comprising a substrate and a stack comprising:
   - a first layer comprising at least one group IV element, the first layer having a first conductivity of a first type of carrier,
   - a second layer comprising at least one group IV element, the second layer having a second conductivity of a second type of carrier,
   - an active region comprising at least one group IV element, the active region being configured to emit or absorb infrared radiation of wavelength λ, said active region being interposed between the first layer and the second layer.
- anisotropically etching of the structure to form the nanowire array.

### BRIEF DESCRIPTION OF THE FIGURES

The aims, objects, features and advantages of the invention will become clearer from the detailed description of an example of the invention which is illustrated by the following accompanying drawings.
Figures 1 and 2 illustrate a nanowire array in an optoelectronic device according to two examples with straight and tapered nanowires, respectively.
Figure 3 illustrates a photonic instrument comprising several optoelectronic devices with enhanced detectivity at selected wavelengths according to an example.
Figure 4 illustrates a pixelated photonic instrument comprising several optoelectronic devices according to another example.
Figures 5A to 5G illustrate steps of the method for manufacturing an optoelectronic device, according to an example.
Figures 6A to 6E are scanning electron microscopy images of the optoelectronic device at different steps of the manufacturing method, according to an example.
Figure 7 illustrates the normalized photocurrent as a function of the wavelength in a GeSn photodetector according to an example, depending on the nanowire diameter.
Figures 8A to 8C illustrate respectively (8A) the current as a function of the applied bias; (8B) the current density as a function of the applied bias; (8C) the dark current density at -0.5V as a function of the nanowire diameter, according to an example.

The figures are given as examples and are not restrictive to the invention. They are principle schematic representations intended to facilitate the understanding of the invention and are thus not necessarily at the same scale as the practical applications. In particular, the thicknesses and/or dimensions of the various layers, nanowires and structures are not representative of reality.

### DETAILED DESCRIPTION

Before describing a detailed review of embodiments and examples of the invention, the following are optional features which may be used in combination or alternatively.

According to an example, the device is a photodetector configured to absorb the infrared radiation of wavelength λ. For example, wavelength λ is comprised between 0.8µm to 20µm.

According to an example, the sides of the nanowires are substantially parallel to the z direction. The wavelength full width at half maximum of the absorbed radiation is thus reduced. The device exhibits enhanced absorption in narrower spectral windows due to leaky mode resonance (LMR) peaks. For the emission, the nanowire geometry increases light extraction and helps controlling its directionality by engineering the nanowire dimensions. The optoelectronic device presents an enhanced sensitivity for a specific absorbed or emitted wavelength. The wavelength resolution of the device is therefore improved. This embodiment is therefore especially suited to applications requiring good precision in the detected wavelength, and especially for spectrometer application in the infrared domain.

According to an example, the sides of the nanowires extend at a substantially oblique angle to the z direction, along at least a portion of the nanowires. The nanowire array thus shows a tapered geometry. Nanowire tapering enables minimizing light reflection by progressively increasing the effective refractive index of the nanowires toward the bulk value. The nanowire array can therefore show an absorption peak that is distributed over a broad wavelength range. The wavelength resolution may be decreased, but the optoelectronic device will show a better sensitivity in terms of intensity of the acquired signal. This embodiment is therefore especially suited to applications requiring the detection of a larger proportion of photon, and especially for imaging/camera application in the infrared domain. Moreover, the applicability of this nanowire geometry can be extended to optoelectronic devices for infrared light emission. The improved light extraction when using nanowires arrays compared to planar films will boost the intensity in the emitted radiation, while also enable a control of the directionality of the emitted light by varying the nanowire geometrical parameters.

According to an example, nanowires present a cross-section in a plane (x,y) substantially perpendicular to the z direction, said cross-section having at least one dimension, for instance the diameter, between 100nm and 1000nm, between 300nm and 800nm.

According to an example, the nanowire array presents a width, in a plane (x,y) substantially perpendicular to the z direction, typically between 5µm and 1000µm, preferably between 5µm and 110µm, for instance between 10µm and 110µm. The width of the nanowire array may be comprised in between 10 µm and 50 µm. The width of the nanowire array can be for example substantially equal to 8 µm or 15 µm. For photodetector applications, the dark current decreases with decreasing size of nanowire array and it can be helpful to tailor the nanowire devices to multiple applications depending on the required signal to noise ratio.

According to an example, adjacent nanowires from the nanowire array are spaced apart by a pitch between 0.5µm and 10µm. The pitch is defined as the distance between the centers of the adjacent nanowires. The pitch has a smaller effect on the optical absorption compared to the diameter. However, tuning the pitch increases the optical coupling to the nanowires and further maximizes the leaky mode resonance peaks at specific wavelengths. As an example, to maximize light absorption at a given wavelength, the pitch should be selected to being half of the wavelength. The pitch can then be more finely tuned, for example in a range of ±20% from the selected pitch. Thus, a pitch of 1µm would be for example an ideal starting point to maximize light absorption at 2 µm, and then fine-tuned for instance in the 0.8 to 1.2µm range.

According to an example, the nanowires present a cross-section in a plane (x,y) substantially perpendicular to the z direction, in the general shape of a circle.

The nanowire array can be shaped in different forms, such as a square or a circle for instance. The width of the nanowire array may be the diameter of the circle, when the nanowire array is shaped as a circle. According to an example, the nanowires can form a circular or square lattice array. It can depend on the required application, such as imaging, spectroscopy, or even detection of single photons.

According to an example, the at least one group IV element is selected from the group consisting of: Ge and Sn.

According to an example, the active region is GeSn-based, preferably consists of GeSn, and comprises a proportion of Sn between 1% and 20%, preferably between 7% to 17%, and preferably between 7% and 12%, for instance between 7% and 8%. This content of Sn in the active region extends the cut-off wavelength of the nanowire array photodetector beyond 2µm to cover a large portion of the SWIR.

According to an example, the substrate is based on at least one from the group consisting of germanium and silicon. A Ge-based substrate is especially suited to obtain ultra-high efficiency device for instance for space applications, wherein the cost is less of an issue. A Si-based substrate is more suited to cost-sensitive applications.

According to an example, the photonic instrument is a spectrometer wherein each of the optoelectronic devices presents a nanowire array geometry defined by at least one parameter chosen from the group consisting of: a dimension of nanowire cross-section taken in a plane (x,y) substantially perpendicular to the z direction, preferably a diameter, a pitch between adjacent nanowires from the nanowire array, and an extension angle of the nanowire sides relatively to the z direction. The nanowire array geometries between the at least two optoelectronic devices are preferably different from one another so that the absorbed infrared radiation of wavelength λ is different between the at least two optoelectronic devices.

According to this example, the photonic instrument comprises at least two, preferably at least five, optoelectronic devices each presenting a nanowire array geometry, and wherein the nanowire array geometries between the at least two optoelectronic devices are different from one another so that the absorbed infrared radiation of wavelength λ is different between the at least two optoelectronic devices. Each nanowire therefore efficiently detects one peak wavelength λ with a certain full width at half maximum (FWHM). In a photodetector application, only a narrow spectral region of the infrared light incident on each nanowire array can be efficiently absorbed and the photogenerated current can be detected by the readout electronics. The collected signal can be processed, for instance through a software, to reconstruct the information about the light source. This embodiment is therefore especially suited to spectrometer application, for instance to determine the absorption spectrum of molecules. Moreover, the instrument according to this embodiment could also be used to improve the efficiency of imaging systems by reconstructing images in different spectral bands.

According to an example, the method comprises, following the anisotropic etching:
- depositing a passivation layer so as to cover the nanowire array,
- depositing a planarisation layer so as to cover the passivation layer, and
- etching the passivation layer and the planarisation layer, to expose a top surface of the nanowire array.

According to an example, the planarisation layer comprises a polymer, said planarisation layer being configured to be at least partially transparent to infrared radiation. The planarisation layer being transparent to an infrared radiation, the absorption of an infrared radiation by parts of the device other than the photoactive ones, is limited. The efficiency of the optoelectronic device is improved.

According to an example, at least the anisotropic etching of the structure is repeated so as to form at least two optoelectronic devices, the method further comprising the determination of a nanowire array geometry for each of the at least two optoelectronic device to be obtained, the nanowire array geometry being defined by at least one parameter chosen from the group consisting of: a dimension of nanowire cross-section taken in a plane (x,y) substantially perpendicular to the z direction, preferably a diameter, a pitch between adjacent nanowires and an extension angle of the nanowire sides relatively to the z direction, so that the nanowire array geometries between the at least two optoelectronic devices are different from one another.

According to one example, providing the structure comprises the transfer of the first layer, the second layer and the active region, typically from a donor substrate, onto the substrate. A better responsivity and a reduced dark current are expected.

By 'optoelectronic device' we mean a device capable of emitting, conveying or receiving light. According to one particular application, such an optoelectronic device comprises a photodetector, in particular a photodetector forming a single pixel or a multipixel array of a sensor, for instance an imaging mean, and for instance a spectrometer or a camera. The invention can be implemented more widely for various optoelectronic devices. For example, the invention may be implemented in the context of any photon detector in the infrared domain.

Unless explicitly stated otherwise, it is specified that, in the context of the present invention, the relative arrangement of a second layer or region or portion interposed between a first layer or region or portion and a third layer or region or portion does not necessarily mean that the layers are directly in contact with one another, but means that the second layer is either directly in contact with the first and third layers, or is separated therefrom by at least one other layer or at least one other element.

Thus, the terms and locutions such as 'to support', 'to surmount' or 'to cover' do not necessarily mean 'in contact with'. By 'in contact', we mean that a thin interface may exist, for example caused by manufacturing variability.

The process steps are understood in the broad sense of carrying out a part of the process and may possibly be carried out in several sub-steps. Several embodiments and examples of the invention involving successive steps of the manufacturing process are described below. Unless explicitly stated, the adjective 'successive' does not necessarily imply, although this is generally preferred, that the steps follow one another immediately, as intermediate steps may separate them.

In particular, some actions of a first step may be followed by actions related to a different step, and other actions of the first step may be repeated afterwards. Thus, the term step does not necessarily mean unitary and inseparable actions in time and in the sequence of the method phases.

A parameter "substantially equal to/lesser than/greater than" a given value is defined as being equal to/lesser than/greater than the given value within plus or minus 10% of that value. A parameter "substantially between" two given values means that the parameter is at least equal to the smaller given value within plus or minus 10% of that value and at most equal to the larger given value within plus or minus 10% of that value. For example, a direction substantially normal to a plane means a direction having an angle of 90±10° to the plane.

A substrate, a layer or a device "based on" a material M is understood to mean a substrate, a layer or a device comprising this material M alone or this material M and optionally other materials, for example alloying elements, impurities or doping elements. For example, a Ge-based structure typically comprises Ge or GeSn or SiGeSn alloys.

In a perfectly conventional way, a structure based on a group IV material is a structure comprising, or consisting of, a material comprising at least one element from column IV of the periodic table.

In the following, the following abbreviations for an M material may be used:
- i-M refers to intrinsic or unintentionally doped M material, according to the terminology usually used in the field of microelectronics for the prefix i-.
- n-M refers to M material doped with N, N+ or N++, according to the terminology usually used in the field of microelectronics for the prefix n-.
- p-M refers to M material doped P, P+ or P++, according to the terminology usually used in the field of microelectronics for the prefix p-.

A reference frame, preferably orthonormal, comprising the x, y, z axes is shown on the figures. The z axis is parallel to the c axis, i.e. to the crystallographic direction [001]

In the context of the present invention, a "transparent" object or material means that the object or material allows at least 80% of the light intensity of the light beam passing through it to pass through. Conversely, a material or surface is considered "opaque" when it absorbs or stops at least 75% of the intensity of an incident light beam.

Dimensional values are understood to be within manufacturing and measurement tolerances. For instance, the fabrication process induces imperfections that result in a nanowire cross-section that is generally circular in shape, although it may not be a perfect circle.

For the purposes of the present invention, the thickness of a layer or substrate is measured in a direction perpendicular to the surface along which this layer or substrate has its maximum extension. The thickness is thus measured in a direction perpendicular to the main faces of the layer or substrate on which the various layers rest. More particularly, the thickness can be measured in the z direction.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

The term "nanowire" is used to name 3D structure in contrast to so-called planar or 2D structures, which have two dimensions in a plane (x,y) far greater than the third dimension normal to the plane (x,y). For example, the nanowires commonly used in the field of optoelectronic devices can take the form of cylindrical nanowires or pyramids (tapered nanowires). Such a nanowire is elongated or oriented in the longitudinal z direction. The longitudinal dimension of the nanowire, along z on the figures, can be greater, and preferably much greater, than the transverse dimensions of the nanowire, in the (x,y) plane on the figures. The longitudinal dimension, in particular for a nanowire, is for example substantially between at least two times, and at least ten times, greater than the transverse dimensions, preferably between three times and five times the transverse dimensions. In the pyramid example, the ratio of longitudinal to transverse dimensions can be fixed. The transverse dimensions can be in between ten to hundreds of nm and the longitudinal dimension can be in the µm range or inferior to 1000 nm, while preferably being greater than the transverse dimension.

In the present patent application, thickness is preferred for a layer and height for a structure (such as a nanowire) or device. The thickness is taken in a direction perpendicular to the main extension plane of the layer, and the height is taken perpendicular to the basal plane (x,y) of the substrate. Thus, a layer typically has a thickness along z, when it extends mainly along an (x,y) plane, and a nanowire has a height along z. The relative terms "on", "over", "under", "underlying" refer to positions taken along the z-direction.

To determine the geometry of the 3D structures and the compositions of the various elements (nanowire, active region, first and second portions) of these 3D structures, and crystalline quality of the material, analyses can be carried out using Scanning Electron Microscopy (SEM), Transmission Electron Microscopy (TEM) or Scanning Transmission Electron Microscopy (STEM), and X-ray diffraction (XRD).

The following non-exhaustive list of techniques can be used: dark field and bright field imaging, weak beam imaging and HAADF (High Angle Annular Dark Field) diffraction, XRD reciprocal space mapping (RSM).

The chemical compositions of the various elements can be de-terminated by combining the well-known XRD-RSM measurements around the asymmetrical (224) reflection with the well-known EDX or X-EDS method, which stands for "energy dispersive x-ray spectroscopy". This method is well suited to analyzing the compositional profiles of small optoelectronic devices. Typically, it remains difficult to estimate Sn precisely in EDX, so it is possible to rely on XRD and then use EDX to locally estimate the compositional profile across a nanowire, portion(s) of nanowire, or layer of the device. It can be implemented on metallurgical sections within a Scanning Electron Microscope (SEM) or on thin slides within a Transmission Electron Microscope (TEM).

In particular, the above-mentioned techniques make it possible to determine the geometry of a nanowire array and nanowire composition, as described in the present invention.

The invention is now described in more detail according to non-limitative examples.

The optoelectronic device is a Group-IV based device. Group IV optoelectronic device according to the invention, and for instance a (Si)GeSn-based device, helps bridging the gap with Group III-V and Group II-VI technologies in the SWIR, MWIR and LWIR domains. Particular applications may concern photodetectors, diodes (or equivalently LED, for light-emitting-diode), lasers, optical modulators, photovoltaics or transistors. The operating radiation 3 wavelength (for an absorbed or emitted radiation) can be comprised between 0.8µm and 20µm.

Hereafter, the examples are described in relation to a photodetector application. The below-mentioned features can however apply for optoelectronic device for other applications, for instance for emissive applications such as light-emitting diodes and lasers. Below, it is therefore only mentioned that a radiation 3 is absorbed by the nanowires 13, inducing the generation of a photocurrent. Features and effects described below can however apply for the emission of a radiation 3 by a light-emitting diode or by a laser.

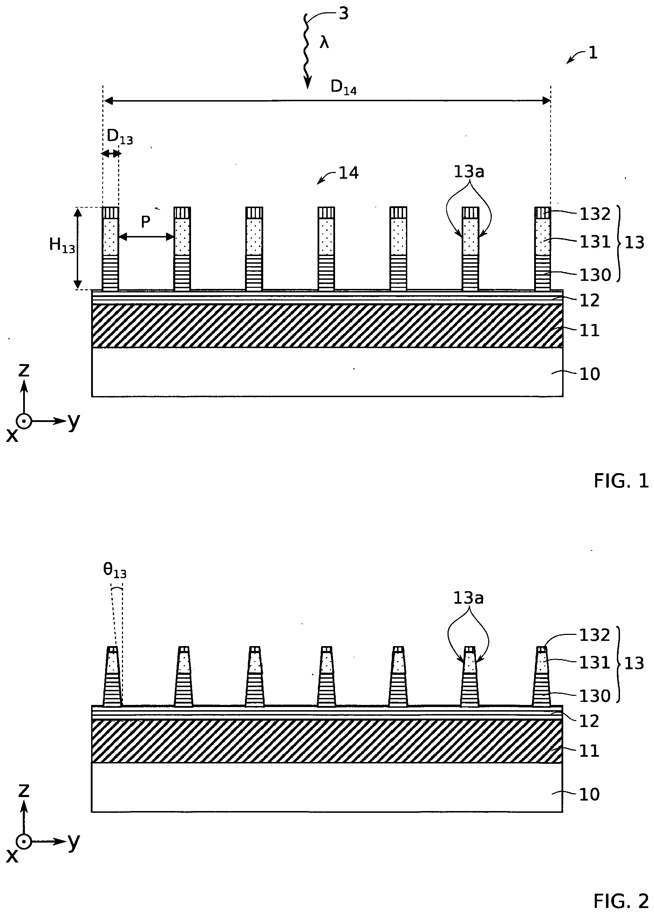

As described for example in figures 1 and 2, the optoelectronic device comprises a substrate 10, preferably a silicon-based substrate, surmounted by a Group-IV-based nanowire array 14. The nanowire array 14 comprises several nanowires 13 spaced apart by a pitch P. The nanowire array 14 extends along at least one direction x perpendicular to the z direction, and preferably along at least two directions of the (x,y) plane, and more preferably along the x and y directions perpendicular to the z direction.

According to an example, the nanowires 13 are one-dimensional (1D) objects presenting a main direction of extension along the z direction, as their height H along the z direction is significantly higher than their dimensions in the (x,y) plane. The height H₁₃ can for example be of the order of one or several microns, for example greater than 200nm and preferably between 600nm and 2µm, for instance between 600 nm and 800 nm, whereas the dimensions of the nanowires 13 in the (x ,y) plane may be less than 1000 nm, typically of the order of one or several hundreds of nanometers. The main direction of extension can be assimilated to the axis of revolution of the nanowire. The height H₁₃ mainly affects the height of the LMR peak, and therefore the absorption intensity, as discussed in Attiaoui, A. et al., Extended Short-Wave Infrared Absorption in Group-IV Nanowire Arrays, Physical Review Applied, (2021) 15(1), 014034.

Compared to existing solutions, and especially compared to planar heterostructure comprising Group-IV elements, the optoelectronic device 1 comprising the nanowire array 14 has the capability/potential to enhance light absorption and reduce dark current. Nanostructuring the photoactive layers into nanowires further enables tuning the resonant peaks depending on the nanowires array 14 geometry.

As compared to II-VI or III-V-based solutions, nanostructuration of Group-IV materials is a scalable fabrication process that is compatible with industrial-standard, wafer-level Si manufacturing processes. The need for cooling the device is further limited. The optoelectronic device can thus be operated at room temperature, for instance between -100°C to 100°C, for instance between 0°C and 30°C. The resulting device 1 can work at room temperature, to reduce costs and enable a broader integration into existing sensing and imaging technologies. A large array(s) surface can therefore be used without hindering performances. Nanowire array can present for example a width up to 110µm, or even up to the 1000µm range, which is not a trivial thing to do for solutions using planar GeSn devices.

The invention therefore improves the efficiency of low-cost thin film GeSn semiconductor infrared photodetectors on Si, for instance operating at room temperature.

The nanowires 13 comprise a first portion 130 having a first conductivity of a first type of carrier. For example, the first portion 130 is a p-doped portion, the first type of carrier being holes. The first portion 130 can comprise Ge or GeSn or SiGeSn, and preferably the first portion 130 consists of p-Ge or p-GeSn or p-SiGeSn. The first portion 130 can present a height comprised between 200 and 2000 nm.

The nanowires 13 comprise a second portion 132 having a second conductivity of a second type of carrier. For example, the second portion 132 is a n-doped portion, the first type of carrier being electrons. The second portion 132 can comprise Ge or GeSn or SiGeSn, and preferably the second portion 132 consists of n-Ge or n-GeSn or n-SiGeSn. The second portion 132 can present a height comprised between 50 and 500 nm. The second portion 132 can present a greater height.

The active region 131 is interposed along the z direction between the first portion 130 and the second portion 132, and preferably directly in contact with these portions. Nanowires 13 can therefore present a p/n or a p/i/n junction. The active region 131 can be an intrinsic layer. The active region 131 can comprise Ge or GeSn or SiGeSn. According to an example, the active region comprises at least two elements of the Group-IV. Preferably the active region 131 comprises or consists of i-GeSn. The active region 131 can present a height comprised between 100 and 2000 nm. The active region 131 extends in a main extension direction substantially perpendicular to the z direction.

The active region 131 preferably comprises a proportion of Sn comprised between 1% and 20%, preferably between 7% and 17%, and preferably between 7% and 8%. Other proportions, for instance 17% and 11%, are also possible. It has indeed been shown that such content of Sn in the active region 131 enhances the efficiency of the photoactive nanowire array 14. Even low Sn content devices have high potential, for instance for use in the 1.5µm telecom band. The first 130 and/or second 132 portions of the nanowire 13 may comprise a similar proportion of Sn. It may be preferred to concentrate Sn in the active region 131 with a Sn proportion higher in the active region 131 than in the first 130 and second 132 portions. For instance, for LEDs and lasers it is preferable to have more Sn in the i-region to promote optical recombination. For detectors, this constraint is much less stringent, and performance may still be satisfactory with less Sn in the n- and p- regions or vice versa.

It is noted that other Group-IV-based compositions can be possible for the first portion 130, the active region 131 and the second portion 132, for instance due to epitaxial growth constraints or manufacturing constraints or depending on the sought application.

The optoelectronic device can further comprise a first electrically conductive contact 19 configured to inject carriers of the second type into the second portion 132 and a second electrically conductive contact 18 configured to inject carriers of the first type into the first portion 130, and.

As illustrated in figures 1 and 2, the nanowire array 14 geometry can be defined by several parameters comprising:
- at least one dimension D₁₃ of the nanowire cross-section taken in a plane (x,y) substantially perpendicular to the z direction, for example a diameter,
- a shape along the z direction,
- the pitch P between adjacent nanowires 13.

Varying at least one of these parameters will modify the absorption properties of the nanowire array 14 and therefore the photonic properties of the resulting device 1. It is therefore understood that varying the nanowire array 14 geometry enables tailoring the photonic properties of the optoelectronic device 1.

Choosing the dimension D₁₃ of the nanowires 13 in the (x,y) plane enables tuning the main wavelength that is absorbed by the active region 131 (i.e the wavelength corresponding to the maximum of the absorption peak). Nanowires 13 can present at least one dimension D₁₃ in the (x,y) plane, preferably all dimensions in the (x,y) plane, and more preferably a diameter, greater than 200nm. The chosen dimension D₁₃ is thus above the lateral resolution limit of conventional lithography techniques. The absorption in the IR domain, and for example between 0,8µm and 20µm, is furthermore improved.

Nanowires 13 can present at least one dimension D₁₃ in the (x,y) plane, preferably all dimensions in the (x,y) plane, and more preferably a diameter, typically less than 1000nm, preferably less than 800nm. The absorption in the IR domain, and for example between 0.8µm and 20 µm, is improved. In a nanowire array 14, all nanowires 13 can present the same dimension D₁₃.

Said dimension D₁₃ may vary along the z direction while remaining within these ranges.

At least some of the nanowires 13 can present a circular cross-section in the plane (x,y)

The shape along the z direction can be modified to tune the width of the absorption peak due to leaky-mode resonance (LMR) peaks, and especially the full width at half maximum of the absorbed wavelength. To do so, the dimensions D₁₃ can be modified along the z direction. Equivalently, the nanowire 13 structure can be tapered. The nanowire array 14 can be engineered with a more constant absorption over a broad wavelength range (high tapering) or exhibit enhanced absorption in narrower spectral windows (low or no tapering). Nanowire 13 tapering further helps to minimize light reflection by progressively increasing the effective refractive index of the nanowires toward the bulk value. A tradeoff between absorption intensity and narrow spectral absorption peaks is thus obtained by controlling the tapering.

As illustrated for example in figure 1 and 2, the nanowire sides 13a can extend at an angle θ₁₃ to the z direction. As illustrated for example in figure 1, θ₁₃ can be substantially zero. The sides 13a of the nanowires 13 can be substantially parallel to the z direction. This structure can also be called a straight structure. Nanowires 13 thus show an enhanced absorption in a narrower spectral window. The wavelength resolution of a resulting photodetector is therefore improved at custom wavelengths.

As illustrated for example in figure 2, θ₁₃ can be strictly greater than zero. The sides 13a of the nanowires 13 can be substantially oblique to the z direction. θ₁₃ can be greater than 2°, preferably 20°, for example substantially equal to 5° or 10°. The nanowire array can therefore show an absorption or emission peak that is distributed over a broad wavelength range. Nanowire structure can further be tapered along a part only of the nanowire 13, and for example on a top part of the nanowire 13.

The nanowires 13 are spaced apart by a pitch P that can be between 0.5µm and 10µm to maximize the intensity of the LMR peaks at different wavelengths. The nanowire array 14 can present width D₁₄ along at least one direction x or y, and preferably both directions x and y, between 5µm and 1000µm, preferably between 8µm and 110 µm. The higher the nanowire array 14 width D₁₄, the higher the intensity of the photocurrent due to a greater number of nanowires in the array 14. This can however induce an increase in the dark current. A tradeoff can therefore be found between these the nanowire array 14 width D₁₄, the nanowires pitch P, and the nanowires diameter D₁₃ depending on the sought for applications at specific wavelengths across the infrared. Said dimensions D₁₄, D₁₃, and P may vary along the x and/or y direction while remaining within these ranges.

For instance, a nanowire array can present the following dimensions:
- D_{14 :} 30µm or 60µm or 110µm, D_{13 :} 700nm, and P : 800nm,
- D₁₃ : 600nm, 800nm, 900nm,
- D₁₄ : between 15µm and 19µm,
- P : 800nm or 1000nm or 1200nm.

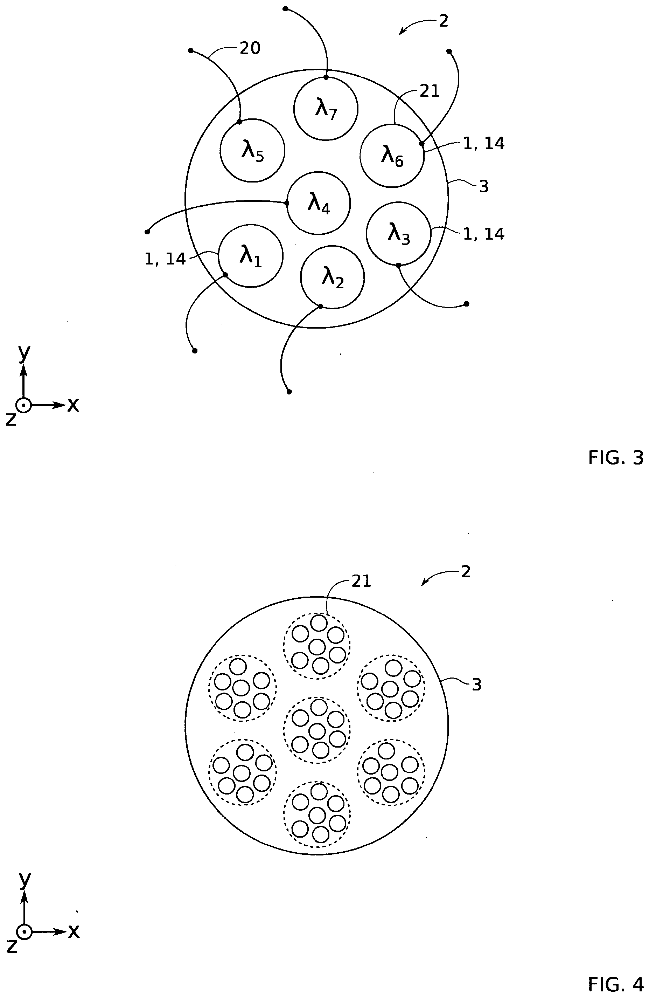

The invention also relates to a photonic instrument 2 comprising several optoelectronic devices and thus several nanowire arrays 14. As illustrated in figure 3, each nanowire array 14 can be separated from one another. Each of the nanowire arrays 14 can be separately electrically wired 20.

According to an example, instrument 2 comprises one or more optoelectronic devices 1 as described above. For the purpose of this description, we consider that each optoelectronic device 1 has one nanowire array 14. The nanowire array 14 geometry can be different between the optoelectronic devices 1. As illustrated, the nanowire array 14 geometries can be together configured to that the nanowire arrays 14 in the instrument 2 are configured to absorb a different wavelength λ₁, λ₂, λ₃, λ₄, ... λₙ from one another. By "absorbing different wavelength", it is meant that the main wavelength λ corresponding to an absorption peak is different between the different nanowire array 14 geometry. It does not necessarily mean that a given wavelength that is absorbed in one nanowire array 14 geometry is not absorbed at all in another geometry. Equivalently, the term "peak wavelength" can be used. At least one geometry parameter as described above is different between the considered nanowire arrays 14. Preferably, at least the dimension D₁₃ differs between different nanowire arrays 14.

Each optoelectronic device 1 in an instrument 2 can form at least a part of a pixel 21, and preferably forms a pixel 21, as illustrated in Figures 3 and 4. Following the absorption of an incident radiation 3 by the optoelectronic devices1, the photogenerated current can be detected by the readout electronics.

According to an example, the photonic instrument 2 is a spectrometer. To enhance wavelength resolution, the nanowire arrays 14 are preferably configured together so that the nanowire arrays 14 in the instrument 2 absorb a different wavelength λ₁, λ₂, λ₃, λ₄, ... λₙ from one another, and nanowires 13 present a straight structure. This will improve the precision of the resulting spectrometer. This approach for fabricating a spectrometer on a Si-based substrate relies on controlling the geometrical parameters of the Group IV nanowire array photodetectors that is then repeated in a pixelated array configuration. Each pixel can correspond to a determined nanowire array set of parameters (and especially diameter, pitch, tapering) to efficiently detect one peak wavelength λₙ with a certain full width at half maximum (FWHM). A narrow spectral region of the infrared radiation incident on the pixelated detector 2 is thus absorbed in each pixel. The associated matrix of the collected signal can be processed through a software to reconstruct the information about the light source. This technique can be used for example to determine the absorption spectrum of molecules.

According to an example, the photonic instrument 2 is a camera. To enhance the absorption of the radiation 3 on a broad wavelength range, nanowires 13 can present a tapered structure. In this example, the nanowire arrays 14 are preferably configured together so that the nanowire arrays 14 in the instrument 2 absorb a substantially similar wavelength λ. The nanowire array 14 geometry can be substantially the same between the optoelectronic devices of the instrument 2.

The associated matrix of the collected signal can be processed through a software to reconstruct the spatial information corresponding to the observed scene. This technique can be used for example for infrared imaging.

As illustrated in Figure 4, each pixel can comprise several optoelectronic devices 1. The optoelectronic devices in one pixel can be configured to absorb different wavelengths. Pixelated wavelength-selective photodetectors can be used to improve the efficiency of imaging systems by reconstructing images in different spectral bands, for example. According to this example, each pixel can be identical to one another.

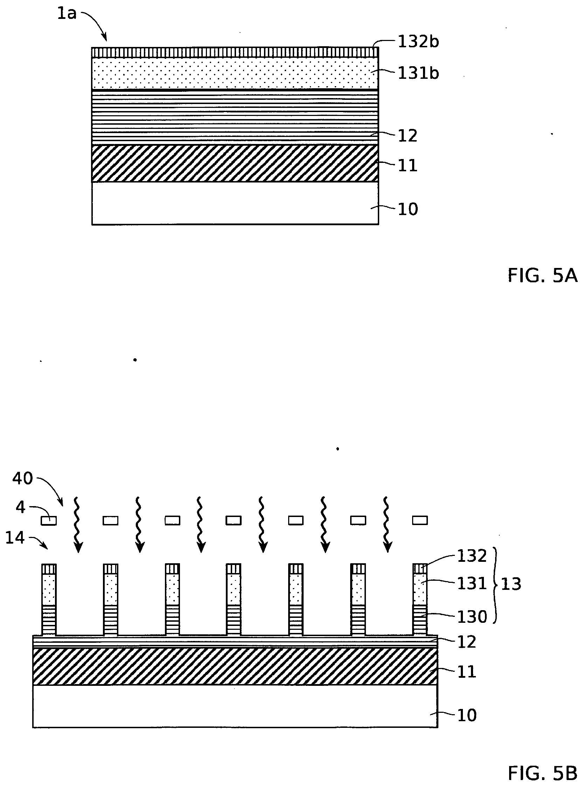

The method for manufacturing the optoelectronic device 1 is now discussed according to an example illustrated in figures 5A to 5G.

A stack structure 1a can firstly be provided, as illustrated in figure 1. The structure 1a comprises a substrate 10 and:
- a first layer 12,
- a second layer 132b,
- an active region 131b, said active region 131b being interposed between the first layer 12 and the second layer 132b,
- additional layers if required.

The first layer 12, the second layer 132b and the active region 131b can each present the same composition as described above relatively respectively to the corresponding first portion 130, the second portion 132 and the active region 131 of the nanowire 13. These layers extend overs the Si-based substrate on the plane (x,y). The structure 1a can be conventionally obtained from an epitaxial growth of Group-IV materials on a silicon-based substrate. It can also be obtained by the transfer of the first layer 12, the second layer 132b and the active region 131b onto the substrate. The stack structure can comprise a Group-IV based intermediate buffer layer 11, for instance with a varying composition (or even being a multi-layer), between the silicon-based substrate and the first layer 12. The intermediate layer 11 can comprise or consist of the same Group-IV material(s) as the first layer 12, preferably without dopant. For instance, the intermediate layer 11 comprises or consists of Ge.

To fabricate the nanowire array 14, the structure 1a can be anisotropically etched. To do so, a mask 4 with apertures 40 can be used. The mask 4 can be based on or consists of a resist or preferably can be based or consist of a metal (typically aluminum) deposited with an evaporator on a pre-patterned resist. An Al-based mask gives better results. The mask 40 can present variable apertures 40 dimensions and pitch, to adapt the nanowire array 14 geometry. The mask can be patterned on the structure 1a, for example directly on the structure 1a, using electron beam lithography or nanoimprint lithography. A resist is conventionally defined as an organic or organo-mineral material that can be shaped by exposure to an electron, photon or X-ray beam, or mechanically. Examples of resists conventionally used in microelectronics include polystyrene (PS), methacrylate (e.g. Polymethyl methacrylate PMMA), hydrosilsesquioxane (HSQ), polyhydroxystyrene (PHS) and others.

The nanowire array 14 can be patterned using a Chlorine-based reactive ion etching (RIE) process, using Chlorine (Cl₂), Oxygen (O₂), and Nitrogen (N₂) gases, as illustrated in figure 5B. The etching of the stack can be performed to etch only partially the first layer 12. The nanowires 13 can therefore extend from a layer 12 extending on the plane (x,y) and presenting the same composition as the first portion 130 of the nanowires 13. The remaining thickness of layer 12, after etching the nanowire array 14, can be typically between 500 nm and 900 nm. The amount of tapering in the nanowires can be controlled by varying the parameters of the RIE, for instance while introducing Argon (Ar) gas.

Prior to the deposition of the passivation layer 16, the nanowire array 14 can be cleaned. For instance, a chemical treatment using HF or HF:HCl can be used. This chemical treatment can be followed by an annealing process at substantially 350°C, for instance for 15 minutes.

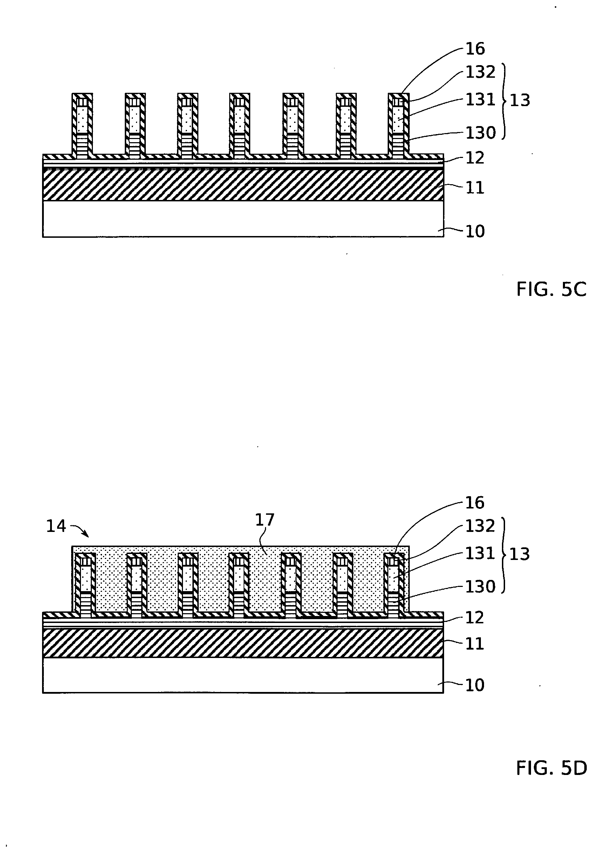

A passivation layer 16 can be deposited on the nanowire array 14, as illustrated in figure 5C. The passivation layer 16 enables minimizing the surface recombination at the nanowire 13 sidewall. The passivation layer 16 can comprise a dielectric material, for instance an oxide. Preferably, the passivation layer 16 typically comprises, or consists of, SiO₂. Other materials are possible, such as SiNₓ, AlOₓ or HfOₓ. It can be formed by plasma-assisted chemical vapor deposition (PECVD) or Atomic Layer Deposition (ALD).

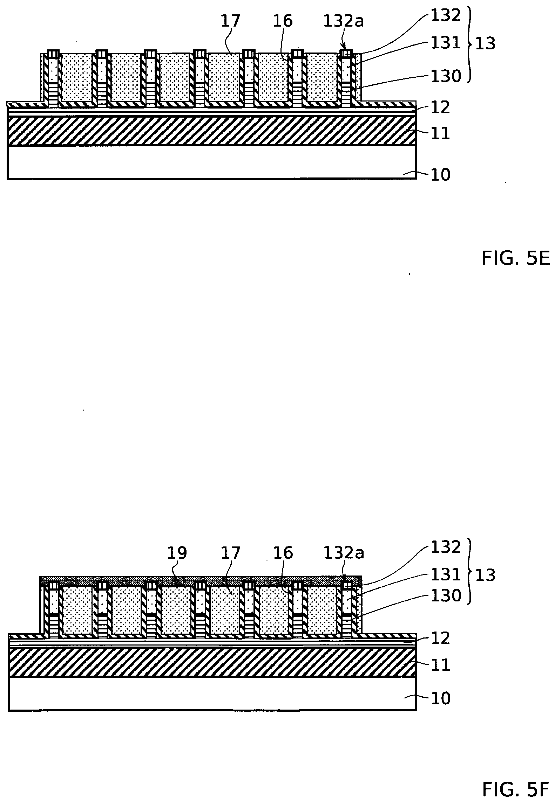

The deposition of the passivation layer 16 can be followed by the deposition of a planarisation layer 17, as illustrated in figure 5D. The planarisation layer 17 can cover only partially the Si-based substrate 10. For example, the planarisation layer 17 can cover the nanowire array 14 without covering all the Si-based substrate. The planarisation layer 17 can be deposited by spin-coating of an infrared transparent polymer. The planarisation layer 17 is preferably a layer having a transparency greater than 80% in the 0.8 to 4µm wavelength range. The planarisation layer 17 is preferably an Accuflo^{®} layer due to its high transparency (typically greater than 80%) in the 0.8 to 4µm wavelength range. Other existing alternatives such as BCB (Benzocyclobutene polymer) are suitable for the fabrication of nanowire device operating in the SWIR, given the high transparency of BCB (typically greater than 80%) up to 3.2µm wavelengths. The passivation layer 16 and any planarisation layer 17 covering the passivation layer 16 can be partially etched-back to expose the top surfaces132a of the n-type nanowire 13 and as least a part of the sidewall of the n-type nanowire 13, as illustrated in figure 5E. Ion beam etching (IBE) can be used. According to another example, the nanowire array 14 can be buried into the passivation layer 16. A polishing step (for example using a chemical mechanical polishing technique) can then be applied to the passivation layer 16, so as to obtain a polished section of the nanowire 13 right at the plane of the polished passivation layer 16.

Indium titanium oxide (ITO) can then be deposited on top of the nanowire array 14 and in electrical contact with the top surface 132a of the nanowires 13 and the n-type region of the sidewall of the nanowire 13, to form the first conductive contact 19, as illustrated in figure 5F.

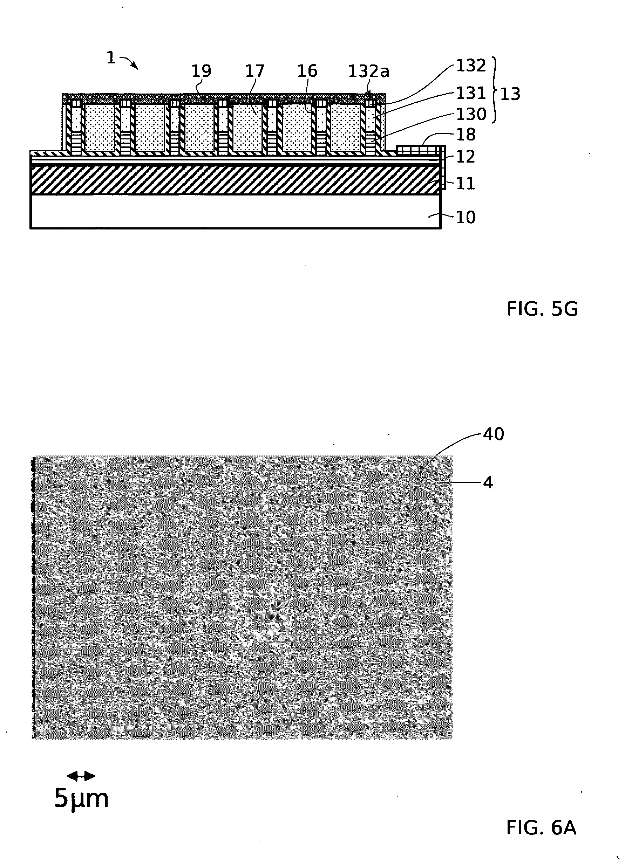

Before or preferably after the deposition of the ITO, metal contacts can be deposited to form the second conductive contact 18, as illustrated in figure 5G. Metal contact can comprise or consists of Ti and/or Au metal. Optical lithography can be used for metal deposition. The ITO contact can be electrically connected to a metal contact, for example a gold pad. Metal contacts can be deposited simultaneously.

For manufacturing the instrument 2, optoelectronic devices can be formed by repeating at least the anisotropic etching of the nanowire array 14. By repeating, it is understood that the corresponding step(s) can be performed successively in a parallel fashion. Optoelectronic devices 1 in an instrument 2 can share a Si-based substrate 10 or not. Several structures 1a can be provided to form the plurality of optoelectronic devices 1 or conversely the plurality of optoelectronic devices 1 can be formed from the same structure 1a.

A particular example is now described in further details, as well as related experimental results. An optoelectronic device 1 comprising a GeSn nanowire array 11 was fabricated, the optoelectronic device 1 comprising:
- an intermediate non-doped Ge first layer 11, on top of a Si substrate 10,
- a first p-Ge layer 12,
- a nanowire array 14 presenting a straight structure and a circular cross-section, and comprising a p-Ge first portion 130, a i-Ge_{0.92}Sn_{0.08} active region 131 and a n-Ge second portion 132,
- a SiO2 passivation layer 16,
- an Accuflo^{®} planarisation layer 17,
- first 19 and second 18 conductive contact as described above.

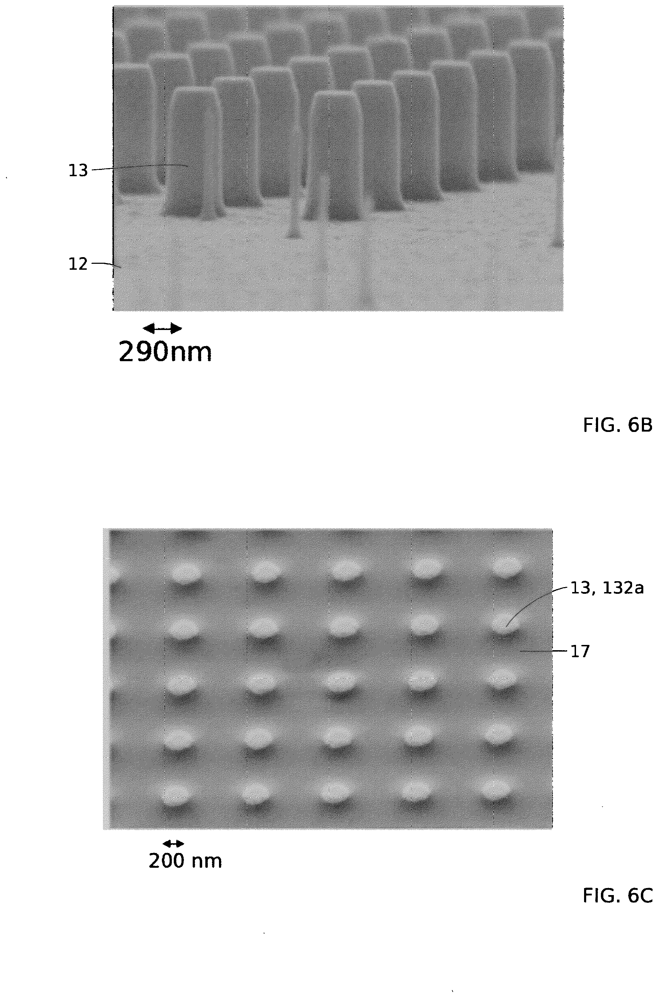

SEM imaging was performed during the manufacturing of the device 1. Figure 6A shows the resist mask 4 patterned on the GeSn stack. Figure 6B shows the obtained nanowire array 14. Residual tapering may appear on top the nanowires 13 due to lithography or etching constraints. This may be due to a reduction of the mask in size during the process and/or else a higher etch rate for the region 132 compared to the region 131 or 130, for instance. It is to be noted that depending on composition and doping for instance of the first 130 and second 132 portions, the n- and/or the p-region may be over/under-etched.

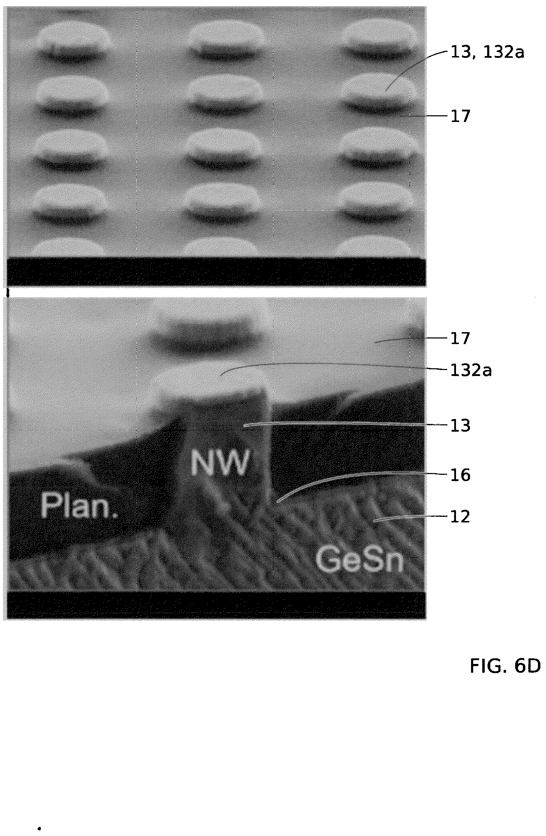

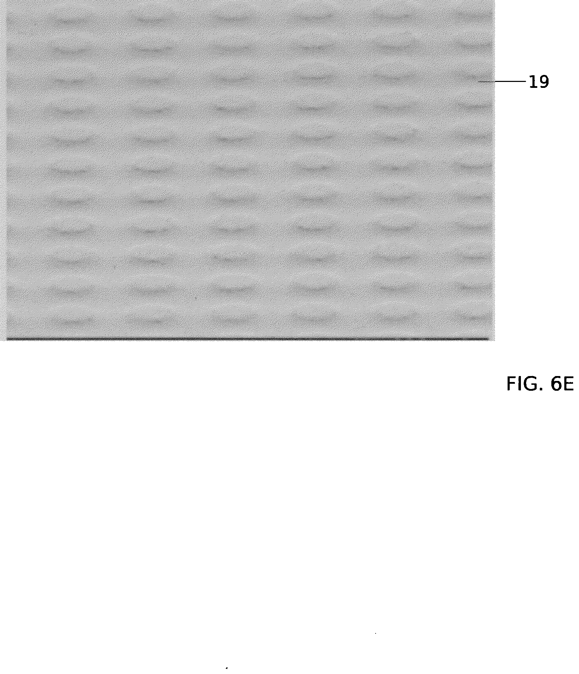

Figure 6C shows the exposed top surfaces 132a of the nanowires 13 after removal of the planarisation layer 17 and the passivation layer 16. Figure 6D shows a top view of a nanowire array 14 and a cross-sectional view of a nanowire 13 as illustrated in figure 6C. Figure 6E shows the nanowire array 14 covered by an ITO contact 19.

The optoelectronic device 1 was mounted on an electrical probe station to perform the optoelectronic characterization. Spectral responsivity curves can be acquired in a lock-in configuration by sending the infrared light source of a FTIR spectrometer on the nanowire array 14.

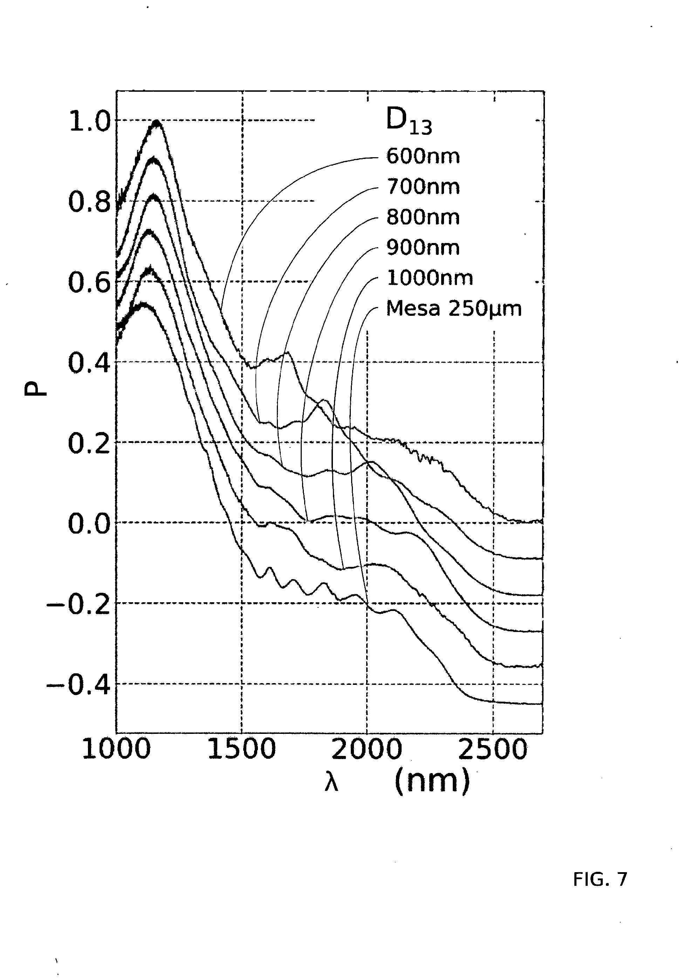

Figures 7 represents the room-temperature normalized photocurrent P as a function of the wavelength, which was acquired upon exposition of the above described optoelectronic device 1 to the infrared light source of a FTIR spectrometer, and as a function of the nanowires 13 diameter D₁₃. This measurement was performed for:
- a nanowire array 14 as described above (with a Sn proportion of 8%), with an array width of 30 µm and diameters ranging from 300 to 1000 nm,
- the sample Mesa 250 µm (with a Sn proportion of 8%) but processed in a conventional MESA planar configuration, for a width of 250 µm.

This figure demonstrates that it is possible to tune the generated photocurrent for a given incident wavelength λ depending on the geometry of the nanowire array 14, and especially their diameter. A cut-off wavelength of 2.6 µm was measured in the nanowire device, while leaky mode resonance peaks are visible below 2.4 µm wavelength. As a comparison, we show the photocurrent from a conventional planar MESA device with a diameter of 250 µm fabricated using the same sample. A cut-off wavelength of 2.4 µm was measured in the device and leaky mode resonance peaks are absent. The reduced cut-off wavelength compared to the nanowire device is due to the presence of compressive strain in the planar device. The compressive strain is released upon etching the nanowire array, thus resulting in a longer cut-off wavelength.

During the development of the invention, measured leaky mode resonance peak wavelengths as a function of the nanowires 13 diameter were compares with the theoretical simulations for the first and a second leaky mode resonance peak simulated as a function the diameter D₁₃ of the cylindrical nanowire (described in Attiaoui, A. et al., Extended Short-Wave Infrared Absorption in Group-IV Nanowire Arrays, Physical Review Applied, (2021) 15(1), 014034.. It was found that measured peaks show a good experimental agreement with the simulations.

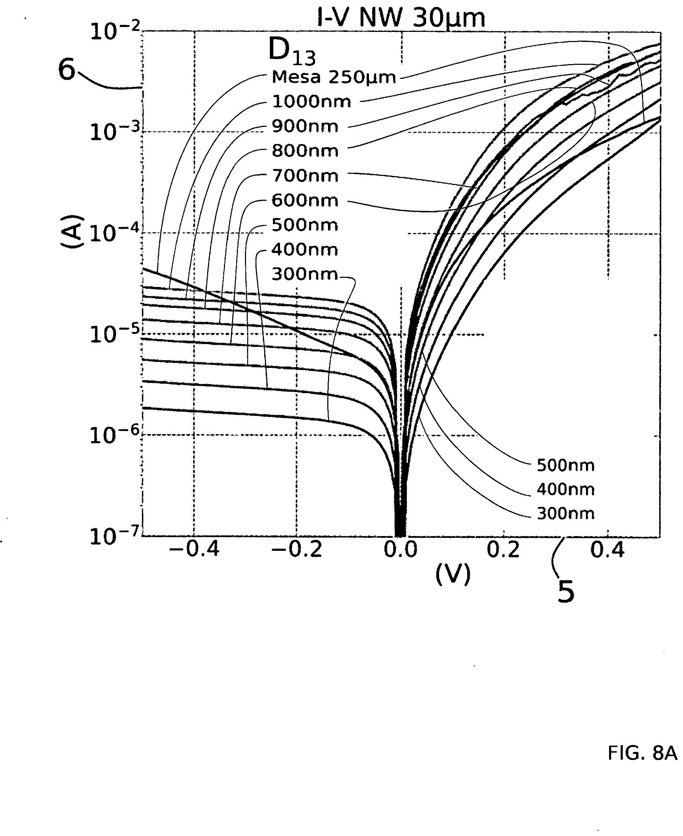

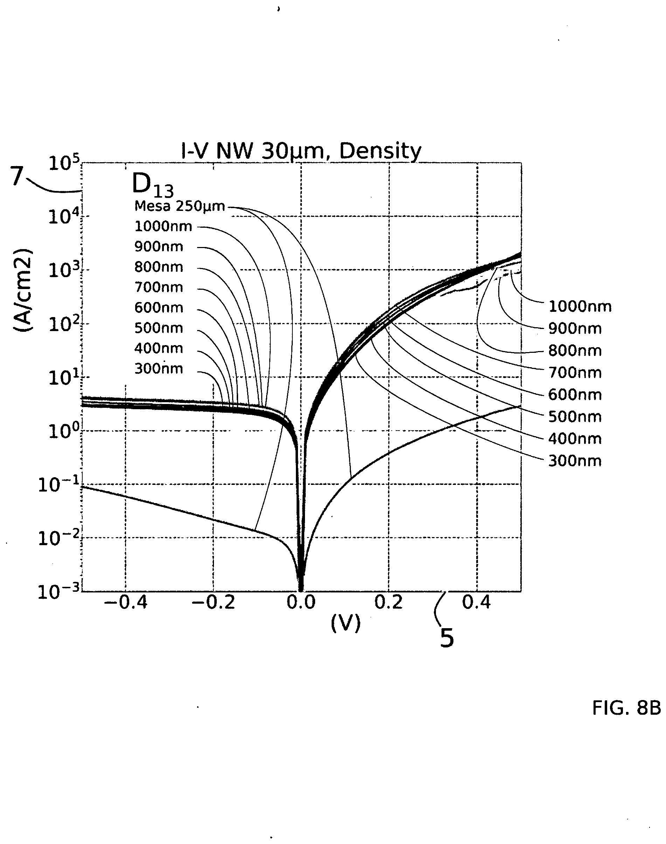

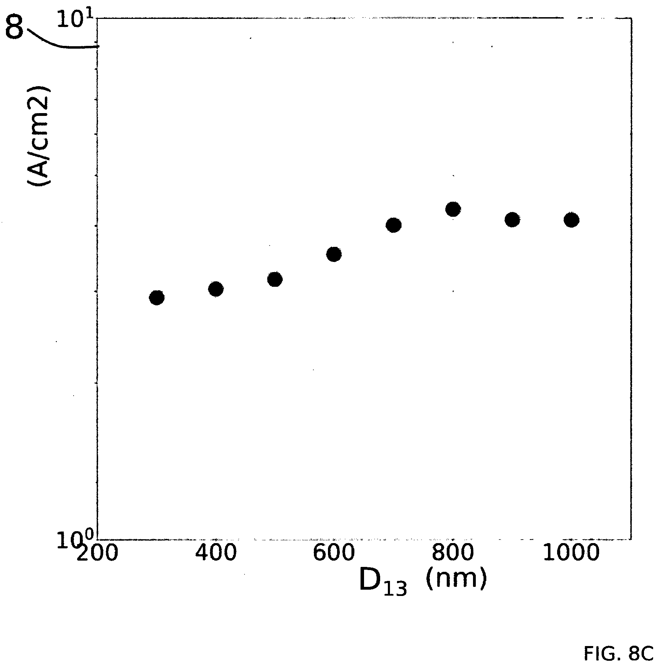

Figure 8A to 8C shows respectively: (8A) the current 6 as a function of the applied bias 5; (8B) the current density 7 as a function of the applied bias 5; (8C) the dark current density 8 at -0.5V as a function of the nanowire diameter D₁₃ for:
- a nanowire array 14 as described above (with a Sn proportion of 8%), with an array width of 30 µm and diameters ranging from 300 to 1000 nm,
- the sample Mesa 250 µm (with a Sn proportion of 8%) but processed in a conventional MESA planar configuration, for a width of 250 µm.
Dark current and dark current density change as a function of the geometrical parameters of the nanowire arrays 14. The dark current increases with an increasing nanowire diameter D₁₃, while the dark current density slightly decreases or can remain rather constant. This shows that the bulk nonradiative recombination at structural defects is the dominant factor and the surface nonradiative recombination is negligible.

The present invention is not limited to the above-described examples. Many other embodiments and examples are possible, for example by combination of previously described features, without going beyond the scope of the invention. For instance, the fabrication method is not limited to the detailed examples. The device can comprise nanowires wherein the first and second portions and the active region are based on, and preferably constituted of, GeSn. The associated fabrication method can be adapted to obtain this feature. Nanowire array 13 can also be obtain starting from first and second layers and an active region that are bonded on the substrate, and preferably on a Si-based substrate. A better responsivity and a reduced dark current are expected. Furthermore, the features described in relation to one aspect of the invention may be combined with another aspect of the invention.

## Claims

1. An optoelectronic device (1) comprising:
- a substrate (10),
- an array of group-IV based heterostructures, the optoelectronic device being **characterized in that** the heterostructures are nanowires (13) forming an array (14) and extending along a z direction, each nanowire comprising:
- a first portion (130) comprising at least one group IV element, the first portion (130) having a first conductivity of a first type of carrier,
- a second portion (132) comprising at least one group IV element, the second portion (132) having a second conductivity of a second type of carrier,
- an active region (131) comprising at least one group IV element, the active region (131) being configured to emit or absorb infrared radiation (3) of wavelength λ, said active region (131) being interposed between the first portion (130) and the second portion (132).

2. The optoelectronic device (1) according to the preceding claim, wherein the device is a photodetector configured to absorb the infrared radiation (3) of wavelength A and wavelength λ is comprised between 0.8µm to 20µm.

3. The optoelectronic device (1) according to any one of the preceding claims, wherein, the nanowires presenting sides (13a), the sides (13a) of the nanowires (13) are substantially parallel to the z direction.

4. The optoelectronic device (1) according to any one of claims 1 and 2, wherein, the nanowires presenting sides (13a), the sides (13a) of the nanowires (13) extend at a substantially oblique angle (θ13) to the z direction, along at least a portion of the nanowires (13).

5. The optoelectronic device (1) according to any one of the preceding claims, wherein nanowires (13) present a cross-section in a plane (x,y) substantially perpendicular to the z direction, said cross-section having at least one dimension (D13), for instance the diameter, between 100nm and 1000nm.

6. The optoelectronic device (1) according to any one of the preceding claims, wherein the nanowire array (14) presents a width (D14), in a plane (x,y) substantially perpendicular to the z direction, between 10µm and 1000µm.

7. The optoelectronic device (1) according to any one of the preceding claims, wherein adjacent nanowires (13) from the nanowire array (14) are spaced apart by a pitch (P) between 0.5µm and 5µm.

8. The optoelectronic device (1) according to any one of the preceding claims, wherein the at least one group IV element is selected from the group consisting of: Ge and Sn.

9. The optoelectronic device (1) according to any one of the preceding claims, wherein the active region (131) is GeSn-based and comprises a proportion of Sn between 1% to 20%, preferably between 7% to 17%.

10. The optoelectronic device (1) according to any one of the preceding claims, wherein the substrate is based on at least one from the group consisting of germanium and silicon.

11. A photonic instrument (2) comprising at least one optoelectronic device (1) according to any of the preceding claims.

12. The photonic instrument (2) according to the preceding claim, wherein the instrument is a spectrometer comprising at least two optoelectronic devices (1) according to any of the preceding claims, and wherein each of the optoelectronic devices (1) presents a nanowire array (14) geometry defined by at least one parameter chosen from the group consisting of: a dimension (D13) of nanowire cross-section taken in a plane (x,y) substantially perpendicular to the z direction, preferably a diameter, a pitch (P) between adjacent nanowires (13) from the nanowire array (14) and an extension angle (θ13) of the nanowire sides (13a) relatively to the z direction, and the nanowire array (14) geometries between the at least two optoelectronic devices (1) are different from one another so that the absorbed infrared radiation (3) of wavelength λ is different between the at least two optoelectronic devices.

13. A method for manufacturing the optoelectronic device (1) according to any one of claims 1 to 10, comprising:
- providing a structure (1a) comprising a substrate (10) and a stack comprising:
• a first layer (12) comprising at least one group IV element, the first layer (12) having a first conductivity of a first type of carrier,
• a second layer (132b) comprising at least one group IV element, the second layer (132b) having a second conductivity of a second type of carrier,
• an active region (131b) comprising at least one group IV element, the active region (131b) being configured to emit or absorb infrared radiation (3) of wavelength A, said active region (131b) being interposed between the first layer (12) and the second layer (132b).
- anisotropically etching of the structure (1a) to form the nanowire array (14).

14. The method according to the preceding claim, the method comprising, following the anisotropic etching:
- depositing a passivation layer (16) so as to cover the nanowire array (14),
- depositing a planarisation layer (17) so as to cover the passivation layer (16), and
- etching the passivation layer (16) and the planarisation layer (17), to expose a top surface (132a) of the nanowire array (14).

15. The method according to any one of the two preceding claims, wherein the planarisation layer (17) comprises a polymer, said planarisation layer (17) being configured to be transparent to infrared radiation (3).

16. The method according to any one of the three preceding claims, wherein at least the anisotropic etching of the structure (1a) is repeated so as to form at least two optoelectronic devices, the method further comprising the determination of a nanowire array (14) geometry for each of the at least two optoelectronic device (1) to be obtained, the nanowire array (14) geometry being defined by at least one parameter chosen from the group consisting of: a dimension (D13) of nanowire (13) cross-section taken in a plane (x,y) substantially perpendicular to the z direction, preferably a diameter, a pitch (P) between adjacent nanowires (13) and an extension angle (θ13) of the nanowire sides (13a) relatively to the z direction, so that the nanowire array (14) geometries between the at least two optoelectronic devices (1) are different from one another.

17. The method according to any one of the four preceding claims, further comprising after anisotropically etching of the structure (1a) to form the nanowire array (14), and preferably after etching the passivation layer:
- a formation of a first electrically conductive contact (19) on top of the nanowire array (14) and in electrical contact with a top surface (132a) of each of the nanowires (13), and
- a formation of a second electrically conductive contact (18) configured to electrically connect the first portion (130) of each nanowire (13).

18. The method according to any one of the five preceding claims, wherein providing the structure (1a) comprises the transfer of the first layer (12), the second layer (132b) and the active region (131b) onto the substrate (10).
